# EUROPEAN PATENT APPLICATION

(11) **EP 2 760 042 A2**
(43) Date of publication of application: **30.07.2014**
(21) Application number: 14153074.1
(22) Date of filing: 29.01.2014
(51) Int. Cl.: H01J 37/18

(54) **Charged particle beam instrument with a specimen pre-evacuation chamber**

(30) Priority: 29.01.2013 JP 2013013935
(71) Applicant: Jeol Ltd., Akishima-shi Tokyo 196-8558 (JP)
(72) Inventor: Matsushita, Mitsuhide, Akishima Tokyo 196-8558 (JP)
(74) Representative: Boult Wade Tennant

(57) **Abstract**

A charged particle beam instrument is offered which has a specimen pre-evacuation chamber where damage and scattering of a specimen can be prevented. The charged particle beam instrument (100) includes the specimen chamber (10), the specimen pre-evacuation chamber (20) connected with the specimen chamber (10) via a gate valve (12), an outflow flow rate adjusting valve (70) for adjusting the flow rate of gas exhausted from the specimen pre-evacuation chamber (20), and a controller (82) for controlling the outflow flow rate adjusting valve (70). The controller (82) performs an operation for controlling the adjusting valve (70) to a first degree of opening, an operation for making a decision as to whether the difference between a first pressure in the pre-evacuation chamber (20) measured by the pressure gauge (30) before the adjusting valve (70) is controlled to the first degree of opening and a second pressure in the pre-evacuation chamber (20) measured by the pressure gauge (30) after the adjusting valve (70) has been controlled to the first degree of opening is greater than a first reference value, and an operation for controlling the adjusting valve (70) to a second degree of opening smaller than the first degree of opening if the decision is affirmative to indicate that the difference between the first and second pressures is greater than the first reference value.

## Description

### BACKGROUND OF THE INVENTION

### 1. Field of the Invention

The present invention relates to a charged particle beam instrument.

### 2. Description of the Related Art

In a charged particle beam instrument such as an electron microscope, a specimen is introduced into a specimen chamber maintained at a vacuum via a specimen pre-evacuation chamber as disclosed, for example, in patent document 1. In the charged particle beam instrument of patent document 1, after a specimen is introduced into the specimen pre-evacuation chamber that is at atmospheric pressure and this pre-evacuation chamber is pumped down to the same degree of vacuum as the specimen chamber by pumping equipment, a gate valve is opened and the specimen is introduced into the specimen chamber. Consequently, the specimen can be introduced into the specimen chamber while maintaining the specimen chamber at a vacuum. With this charged particle beam instrument, the specimen can be extracted from the specimen chamber while maintaining the specimen chamber at a vacuum by taking the specimen out of the specimen chamber via the specimen pre-evacuation chamber.

### Citation List

### Patent Documents

Patent document 1: JP-A-2009-48801

In this charged particle beam instrument, however, when the specimen pre-evacuation chamber is pre-evacuated in introducing a specimen into the specimen chamber, the pressure variation per unit time inside the specimen pre-evacuation chamber may become large. Especially, immediately after rough pumping is started using a rotary pump or immediately after the working pump is switched to a turbomolecular pump after rough pumping is done using a rotary pump, the pressure variation increases. Furthermore, when the specimen pre-evacuation chamber is vented in taking the specimen out of the specimen chamber, the pressure variation per unit time within the specimen pre-evacuation chamber may increase.

Because of large pressure variations in the specimen pre-evacuation chamber, the specimen may be damaged. If the specimen is pulverulent body, the specimen may be scattered. Furthermore, where an observation is made using an environmental cell permitting observation of a specimen at a pressure higher than the pressure inside the specimen chamber by introducing a gas to vicinities of the specimen, a diaphragm used in the environmental cell may be destroyed by pressure variations inside the specimen pre-evacuation chamber.

### SUMMARY OF THE INVENTION

It would be desirable to provide a charged particle beam instrument having a specimen pre-evacuation chamber in which damage and scattering of a specimen can be prevented.
(1) A charged particle beam instrument associated with the present invention has:
   a specimen chamber maintained at a vacuum; a specimen pre-evacuation chamber connected with the specimen chamber via a gate valve; a vacuum pump for evacuating the specimen pre-evacuation chamber; an outflow flow rate adjusting valve for adjusting the flow rate of gas exhausted from the specimen pre-evacuation chamber by the vacuum pump; a pressure gauge for measuring the pressure inside the specimen pre-evacuation chamber; and a controller for controlling the outflow flow rate adjusting valve. The controller performs an operation for controlling the outflow flow rate adjusting valve to a first degree of opening, an operation for making a decision as to whether the difference between a first pressure inside the specimen pre-evacuation chamber measured by the pressure gauge before the outflow flow rate adjusting valve is controlled to the first degree of opening and a second pressure inside the specimen pre-evacuation chamber measured by the pressure gauge after the outflow flow rate adjusting valve has been controlled to the first degree of opening is greater than a first reference value, and an operation for controlling the outflow flow rate adjusting valve to a second degree of opening smaller than the first degree of opening if the decision is affirmative to indicate that the difference between the first and second pressures is greater than the first reference value.
      In this charged particle beam instrument, when the specimen pre-evacuation chamber is pre-evacuated, large pressure variations which would normally damage or scatter the sample can be prevented. Consequently, damage and scattering of the specimen within the specimen pre-evacuation chamber can be prevented.
(2) In one embodiment of this charged particle beam instrument, the controller may perform an operation for making a decision as to whether the difference between the first and second pressures is smaller than a second reference value and an operation for controlling the outflow flow rate adjusting valve to a third degree of opening greater than the first degree of opening if the decision is affirmative to indicate that the difference between the first and second pressures is smaller than the second reference value.
(3) In another embodiment of this charged particle beam instrument, there may be further provided a gas supply portion for introducing gas into the specimen pre-evacuation chamber and an inflow flow rate adjusting valve for adjusting the flow rate of the gas introduced into the specimen pre-evacuation chamber by the gas supply portion. The controller may further operate to control the inflow flow rate adjusting valve. The controller may perform: an operation for controlling the inflow flow rate adjusting valve to a fourth degree of opening; an operation for making a decision as to whether the difference between a third pressure inside the specimen pre-evacuation chamber measured by the pressure gauge before the inflow flow rate adjusting valve is controlled to the fourth degree of opening and a fourth pressure inside the specimen pre-evacuation chamber measured by the pressure gauge after the inflow flow rate adjusting valve has been adjusted to the fourth degree of opening is greater than a third reference value; and an operation for controlling the inflow flow rate adjusting valve to a fifth degree of opening smaller than the fourth degree of opening if the decision is affirmative to indicate that the difference between the third and fourth pressures is greater than the third reference value.
(4) In a further embodiment of this charged particle beam instrument, the controller may perform an operation for making a decision as to whether the difference between the third and fourth pressures is smaller than a fourth reference value and an operation for controlling the inflow flow rate adjusting valve to a sixth degree of opening greater than the fourth degree of opening if the decision is affirmative to indicate that the difference between the third and fourth pressures is smaller than the fourth reference value.
(5) Another charged particle beam instrument associated with the present invention includes: a specimen chamber maintained at a vacuum; a specimen pre-evacuation chamber connected with the specimen chamber via a gate valve; a gas supply portion for introducing gas into the specimen pre-evacuation chamber; an inflow flow rate adjusting valve for adjusting the flow rate of the gas introduced into the specimen pre-evacuation chamber by the gas supply portion; a pressure gauge for measuring the pressure inside the specimen pre-evacuation chamber; and a controller for controlling the inflow flow rate adjusting valve. The controller performs an operation for controlling the inflow flow rate adjusting valve to a fourth degree of opening; an operation for making a decision as to whether the difference between a third pressure inside the specimen pre-evacuation chamber measured by the pressure gauge before the inflow flow rate adjusting valve is controlled to the fourth degree of opening and a fourth pressure inside the specimen pre-evacuation chamber measured by the pressure gauge after the inflow flow rate adjusting valve has been controlled to the fourth degree of opening is greater than a third reference value; and an operation for controlling the inflow flow rate adjusting valve to a fifth degree of opening smaller than the fourth degree of opening if the decision is affirmative to indicate that the difference between the third and fourth pressures is greater than the third reference value.

In this charged particle beam instrument, when the specimen pre-evacuation chamber is vented, great pressure variations which would normally damage or scatter the specimen can be prevented. Consequently, the specimen in the specimen pre-evacuation chamber can be prevented from being damaged or scattered.

### BRIEF DESCRIPTION OF THE DRAWINGS

FIG. 1 is a vertical cross section of a charged particle beam instrument associated with one embodiment of the present invention.
FIG. 2 is a block diagram of exhaust and suction systems for a specimen chamber and a specimen pre-evacuation chamber included in the charged particle beam instrument shown in FIG. 1.
FIG. 3 is a flowchart illustrating one example of sequence of operations performed by a controller included in the charged particle beam instrument shown in FIG. 2 to adjust the inflow flow rate.
FIG. 4 is a flowchart illustrating another example of sequence of operations performed by the controller.

### DETAILED DESCRIPTION OF THE INVENTION

The preferred embodiment of the present invention is hereinafter described in detail with reference to the drawings. It is to be understood that the embodiment provided below does not unduly restrict the scope of the present invention delineated by the appended claims and that not all the configurations described below are essential constituent components of the invention.

### 1. Charged Particle Beam Instrument

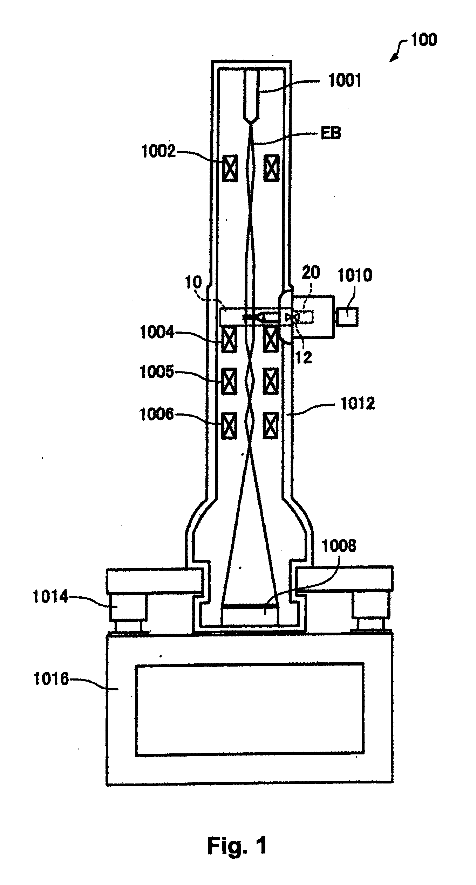

The configuration of a charged particle beam instrument associated with one embodiment of the present invention is described by referring to FIG. 1, where the instrument is generally indicated by reference numeral 100. The instrument 100 has a specimen chamber 10 and a specimen pre-evacuation chamber 20. Exhaust systems and air intake systems for these chambers 10 and 20 (described later) are not shown in FIG. 1 for the sake of convenience.

As shown in FIG. 1, the charged particle beam instrument 100 is configured including an electron beam source 1001, an illumination lens 1002, the specimen chamber 10, a gate valve 12, the specimen pre-evacuation chamber 20, an objective lens 1004, an intermediate lens 1005, a projector lens 1006, an electron imager 1008, and a specimen holder 1010. In the present embodiment, it is assumed that the charged particle beam instrument 100 is a transmission electron microscope (TEM). FIG. 1 shows the state in which a specimen is held on the specimen holder 1010 and disposed within the specimen chamber 10.

The electron beam source 1001, illumination lens 1002, objective lens 1004, intermediate lens 1005, and projector lens 1006 are housed in an electron optical column 1012. The interior of the column 1012 is evacuated by vacuum pumping equipment (not shown).

The electron beam source 1001 emits an electron beam EB by accelerating electrons, which are released from a cathode, using an anode. A well-known electron gun can be used as the electron beam source 1001.

The illumination lens 1002 is disposed behind the electron beam source 1001 and operates such that the electron beam EB generated by the electron beam source 1001 is directed at the specimen. The illumination lens 1002 is configured, for example, including a plurality of condenser lenses (not shown).

In the specimen chamber 10, the specimen is held by the specimen holder 1010. The specimen chamber 10 is a space located within the electron optical column 1012. The specimen chamber 10 is maintained at a vacuum, i.e., at a subatmospheric pressure. The pressure inside the specimen chamber 10 is approximately 10⁻⁵ Pa, for example. Within the specimen chamber 10, the specimen is irradiated with a charged particle beam (such as an electron beam). The specimen is moved from the specimen pre-evacuation chamber 20 to the specimen chamber 10 and vice versa by manipulating the specimen holder 1010.

The specimen pre-evacuation chamber 20 is connected with the specimen chamber 10 via the gate valve 12. Details of the specimen chamber 10 and specimen pre-evacuation chamber 20 will be described in further detail later.

The objective lens 1004 is located behind the illumination lens 1002. The objective lens 1004 is a first stage of lens that focuses the electron beam EB transmitted through the specimen.

The intermediate lens 1005 is located behind the objective lens 1004. The projector lens 1006 is positioned behind the intermediate lens 1005. The intermediate lens 1005 and projector lens 1006 further magnify the image (electron microscope image) focused by the objective lens 1004 and focus the magnified image onto the imager 1008.

The electron imager 1008 has a detector for detecting the electron beam EB. For example, the detector is a CCD camera having a two-dimensional array of CCDs. The imager 1008 detects the electron microscope image focused by the projector lens 1006 and outputs information about this electron microscope image.

In the illustrated example, the charged particle beam instrument 100 is installed on a pedestal 1016 via vibration isolators 1014.

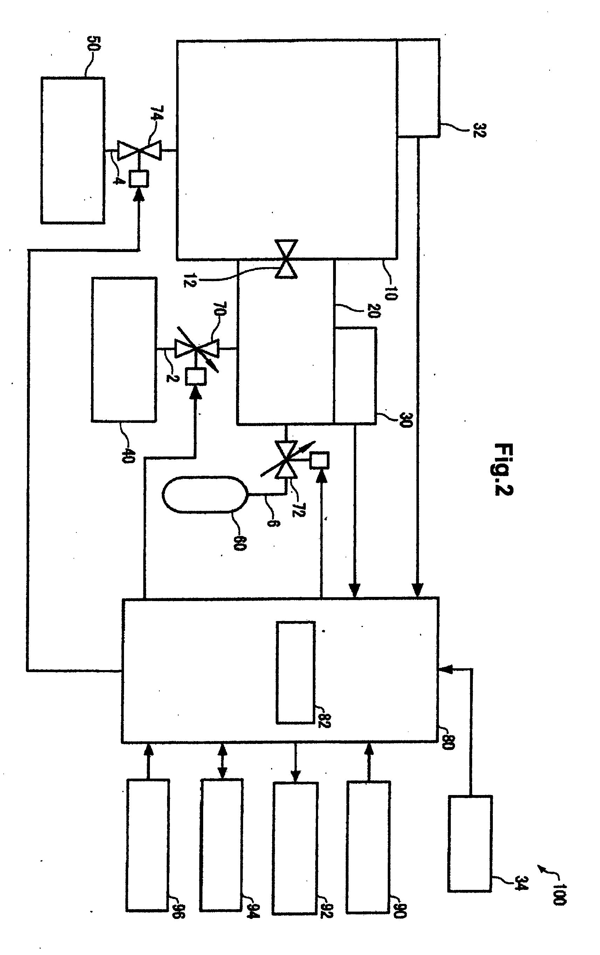

FIG. 2 shows the configurations of the exhaust and intake systems for the specimen chamber 10 and specimen pre-evacuation chamber 20 of the charged particle beam instrument 100.

As shown in FIG. 2, the charged particle beam instrument 100 further includes pressure gauges 30, 32, 34, vacuum pumps 40, 50, a gas supply portion 60, an outflow flow rate adjusting valve 70, an inflow flow rate adjusting valve 72, a signal processor 80, a manipulation portion 90, a display portion 92, a storage portion 94, and a storage medium 96.

A specimen chamber exhaust tube 4 equipped with a specimen chamber exhaust valve 74 is connected with the specimen chamber 10. The specimen chamber 10 is pumped down by the vacuum pump 50 via the specimen chamber exhaust tube 4. The pressure inside the specimen chamber 10 can be measured with the pressure gauge 32.

The specimen pre-evacuation chamber 20 can be placed in communication with the specimen chamber 10 by opening the gate valve 12. Consequently, the specimen can be moved between the specimen chamber 10 and the specimen pre-evacuation chamber 20. A specimen pre-evacuation chamber exhaust tube 2 equipped with the outflow flow rate adjusting valve 70 is connected with the specimen pre-evacuation chamber 20. The pre-evacuation chamber 20 is evacuated by the vacuum pump 40 via the specimen pre-evacuation chamber exhaust tube 2. In consequence, the pressure inside the specimen pre-evacuation chamber 20 can be varied, for example, from atmospheric pressure to the same pressure as the pressure inside the specimen chamber 10. Furthermore, a specimen pre-evacuation chamber inlet tube 6 equipped with the inflow flow rate adjusting valve 72 is connected with the specimen pre-evacuation chamber 20. A gas is introduced from the gas supply portion 60 into the specimen pre-evacuation chamber 20 via the specimen pre-evacuation chamber inlet tube 6. As a result, the pressure inside the specimen pre-evacuation chamber 20 can be varied, for example, from the same pressure as the pressure inside the specimen chamber 10 to atmospheric pressure. The pressure inside the specimen pre-evacuation chamber 20 can be measured with the pressure gauge 30.

In the charged particle beam instrument 100, the specimen can be introduced into the specimen chamber 10 while maintaining the specimen chamber 10 at a high degree of vacuum by introducing the specimen into the specimen chamber 10 via the specimen pre-evacuation chamber 20. Furthermore, the charged particle beam instrument 100 permits the specimen to be taken out of the specimen chamber 10 while maintaining the specimen chamber 10 at a high degree of vacuum by taking the specimen out of the specimen chamber 10 via the specimen pre-evacuation chamber 20.

The gate valve 12 acts as a partition wall that hermetically isolates the specimen chamber 10 and the specimen pre-evacuation chamber 20 from each other. For example, the gate valve 12 is a vacuum valve. The gate valve 12 permits the specimen pre-evacuation chamber 20 to be maintained at atmospheric pressure while the specimen chamber 10 is kept at a vacuum.

The pressure gauge 30 measures the pressure inside the specimen pre-evacuation chamber 20. The pressure gauge 32 measures the pressure inside the specimen chamber 10. The pressure gauge 34 measures the atmospheric pressure (ambient pressure). Information about the pressures measured by the pressure gauges 30, 32, and 34 is output to the processor 80 (controller 82).

The vacuum pump 40 evacuates the specimen pre-evacuation chamber 20. For instance, the vacuum pump 40 is a turbomolecular pump. For example, an oil rotary pump (not shown) is connected to the outlet port of the turbomolecular pump. The vacuum pump 40 is not restricted to a turbomolecular pump. The vacuum pump 40 may also be other vacuum pump such as a diffusion pump. The vacuum pump 40 evacuates the specimen pre-evacuation chamber 20 via the specimen pre-evacuation chamber exhaust tube 2.

The vacuum pump 50 evacuates the specimen chamber 10. The vacuum pump 50 is a turbomolecular pump, for example. The vacuum pump 50 is not restricted to a turbomolecular pump. It may be other vacuum pump such as a diffusion pump. The vacuum pump 50 evacuates the specimen chamber 10 via the specimen chamber exhaust tube 4 fitted with the specimen chamber exhaust valve 74. The specimen chamber exhaust valve 74 is opened and closed under control of the controller 82.

The gas supply portion 60 introduces a gas into the specimen pre-evacuation chamber 20. For example, the gas supply portion 60 is a compressed gas cylinder in which compressed high-pressure gas is received. By introducing a gas into the specimen pre-evacuation chamber 20 by the gas supply portion 60, the specimen pre-evacuation chamber 20 can be brought from the same pressure as the pressure inside the specimen chamber 10 to atmospheric pressure. The gas supplied by the gas supply portion 60 is an inert gas such as nitrogen or argon. The gas supply portion 60 introduces a gas into the specimen pre-evacuation chamber 20 via the specimen pre-evacuation chamber inlet tube 6.

The outflow flow rate adjusting valve 70 adjusts the flow rate of gas exhausted from the specimen pre-evacuation chamber 20 by the pump 40. The adjusting valve 70 is mounted in the specimen pre-evacuation chamber exhaust tube 2 that interconnects the specimen pre-evacuation chamber 20 and the pump 40. The outflow flow rate of the outflow flow rate adjusting valve 70 varies according to its degree of opening. The outflow flow rate of the outflow flow rate adjusting valve 70 can be increased by increasing the degree of opening of the valve 70. This valve 70 is operated, for example, by being supplied with a voltage or current. Furthermore, the outflow flow rate adjusting valve 70 may be pneumatically actuated. The degree of opening of the outflow flow rate adjusting valve 70 is controlled by the controller 82.

The inflow flow rate adjusting valve 72 adjusts the flow rate of the gas introduced into the specimen pre-evacuation chamber 20 by the gas supply portion 60. The adjusting valve 72 is mounted in the specimen pre-evacuation chamber inlet tube 6 which interconnects the specimen pre-evacuation chamber 20 and the gas supply portion 60. The inflow flow rate of the inflow flow rate adjusting valve 72 varies according to its degree of opening. The inflow flow rate of the inflow flow rate adjusting valve 72 can be increased by increasing the degree of opening of the valve. For example, the inflow flow rate adjusting valve 72 is operated by being supplied with a voltage or current. Alternatively, the adjusting valve 72 may be pneumatically actuated. The degree of opening of the adjusting valve 72 is controlled by the controller 82.

The manipulation portion 90 obtains a control signal corresponding to a user's manipulation and sends the control signal to the processor 80. For example, the manipulation portion 90 is a button, key, touch panel display, microphone, or the like.

The results of processing performed by the processor 80 are displayed as character information, graphic information, or other kind of information on the display portion 92 based on the display signal entered from the processor 80. For example, the display portion 92 is a CRT, LCD, touch panel display, or the like.

Programs and data permitting the processor 80 to perform various kinds of computational processing and control processing operations are stored in the storage portion 94. The storage portion 94 is used as a working area for the processor 80. Furthermore, the storage portion 94 is used to temporarily store the control signal entered from the manipulation portion 90, program and data read from the storage medium 96, and the results of calculation executed by the processor 80 according to various programs.

The storage medium 96 is a computer-readable storage medium for storing various programs and data. Furthermore, the storage medium 96 may function as an archival storage device for storing data that need to be stored over the long term out of data created by the processing performed by the processor 80. The storage medium 96 can be accomplished, for example, by an optical disc (such as CD or DVD), magnetooptical disc (MO), magnetic disc, hard disc, magnetic tape, or memory (such as ROM or flash memory).

The processor 80 performs various kinds of computational processing according to either a program stored in the storage portion 94 or a program stored in the storage medium 96. The functions of the processor 80 can be accomplished by various kinds of hardware, e.g., processors (such as CPU or DSP) or ASIC (such as a gate array) or software.

In the present embodiment, the processor 80 operates as the controller 82 controlling the outflow flow rate adjusting valve 70 and inflow flow rate adjusting valve 72 described below by executing a program stored in the storage portion 94. Alternatively, this program may be received from a server connected with a wired or wireless communication network, stored in the storage portion 94 or storage medium 96, and executed. At least a part of the processor 80 may be accomplished by dedicated hardware circuitry.

During pre-evacuation of the specimen pre-evacuation chamber 20 for introducing a specimen into the specimen chamber 10, the controller 82 performs processing (such as a subroutine) for adjusting the outflow flow rate.

In this subroutine for adjusting the outflow flow rate, the controller 82 performs an operation for controlling the outflow flow rate adjusting valve 70 to a first degree of opening (may also be referred to as the initial degree of opening), an operation for making a decision as to whether the difference between an initial pressure P1 inside the specimen pre-evacuation chamber 20 measured by the pressure gauge 30 before the adjusting valve 70 is controlled to the first degree of opening and the current pressure P2 in the specimen pre-evacuation chamber 20 measured by the pressure gauge 30 after the adjusting valve 70 has been controlled to the first degree of opening, i.e., εp₂₋₁ = |P2 - P1|, is greater than a first reference value εs1, and an operation for controlling the outflow flow rate adjusting valve 70 to a second degree of opening smaller than the first degree of opening if the difference εp₂₋₁ is judged to be greater than the first reference value εs1.

For example, the first reference value εs1 is an upper limit of pressure difference (pressure variation) at which neither destruction nor scattering of the specimen occurs. The first reference value εs1 is preset, for example, according to the pressure resistance of the specimen. The first and second degrees of opening are preset, for example, according to the pumping capability of the vacuum pump 40. The controller 82 obtains the initial pressure P1 and the current pressure P2, for example, at predetermined intervals of time.

In the processing for adjusting the outflow flow rate, the controller 82 performs an operation for making a decision as to whether the difference εp₂₋₁ between the initial pressure P1 and the current pressure P2 is smaller than a second reference value εs2 and an operation for controlling the outflow flow rate adjusting valve 70 to a third degree of opening greater than the first degree of opening if the decision is affirmative to indicate that the difference εp₂₋₁ is smaller than the second reference value εs2.

The second reference value εs2 is preset to a value smaller than the first reference value εs1. For example, the second reference value εs2 is a lower limit of the pressure difference (pressure variation) at which the specimen pre-evacuation chamber 20 can be evacuated efficiently.

In the charged particle beam instrument 100, the controller 82 performs the aforementioned processing for adjusting the outflow flow rate. Consequently, during pre-evacuation of the specimen pre-evacuation chamber 20, the difference εp₂₋₁, i.e., the variation in the pressure inside the specimen pre-evacuation chamber 20, can be set within a predetermined range, εs2 ≤ εp₂₋₁ ≤ εs1.

Furthermore, during venting of the specimen pre-evacuation chamber 20 for taking the specimen out of the specimen chamber 10 via the specimen pre-evacuation chamber 20, the controller 82 performs processing for adjusting the inflow flow rate.

In the processing for adjusting the inflow flow rate, the controller 82 performs an operation for adjusting the inflow flow rate adjusting valve 72 to a fourth degree of opening (initial degree of opening), an operation for making a decision as to whether the difference εp₄₋₃ = |P4 - P3| between a pressure P3 (initial pressure P3) inside the specimen pre-evacuation chamber 20 measured by the pressure gauge 30 before the adjusting valve 72 is controlled to the fourth degree of opening (initial degree of opening) and the current pressure P4 inside the specimen pre-evacuation chamber 20 measured by the pressure gauge 30 after the adjusting valve 72 has been controlled to the fourth degree of opening is greater than a third reference value εs3, and an operation for controlling the adjusting valve 72 to a fifth degree of opening smaller than the fourth degree of opening if the difference εp₄₋₃ is judged to be greater than the third reference value εs3.

For example, the third reference value εs3 is an upper limit of pressure difference (pressure variation) at which neither destruction nor scattering of the specimen occurs. The third reference value εs3 is preset, for example, according to the pressure resistance of the specimen. For instance, the third reference value εs3 may be identical with the first reference value εs1. The third and fourth degrees of opening are preset, for example, according to the gas supply capabilities of the gas supply portion 60. The controller 82 obtains the initial pressure P3 and the current pressure P4, for example, at predetermined intervals of time.

In addition, in the processing for adjusting the inflow flow rate, the controller 82 performs an operation for making a decision as to whether the difference εp₄₋₃ between the initial pressure P3 and the current pressure P4 is smaller than the fourth reference value εs4 and an operation for controlling the inflow flow rate adjusting valve 72 to a fifth degree of opening smaller than the fourth degree of opening if the decision is affirmative to indicate that the difference εp₄₋₃ is smaller than the fourth reference value εs4.

The fourth reference value εs4 is preset to a value smaller than the third reference value εs3. For example, the fourth reference value εs4 is a lower limit of the pressure difference (pressure variation) at which the a gas can be efficiently introduced into the specimen pre-evacuation chamber 20.

In the charged particle beam instrument 100, the controller 82 performs the aforementioned processing for adjusting the inflow flow rate. Consequently, during venting of the specimen pre-evacuation chamber 20, the difference εp₄₋₃ (i.e., the variation of the pressure inside the specimen pre-evacuation chamber 20) can be set within a preset range, εs4 ≤ εp₄₋₃ ≤ εs3.

### 2. Processing of Controller of Charged Particle Beam Instrument

The processing performed by the controller 82 of the charged particle beam instrument 100 is next described.

### 2.1. Processing for Adjusting Outflow Flow Rate

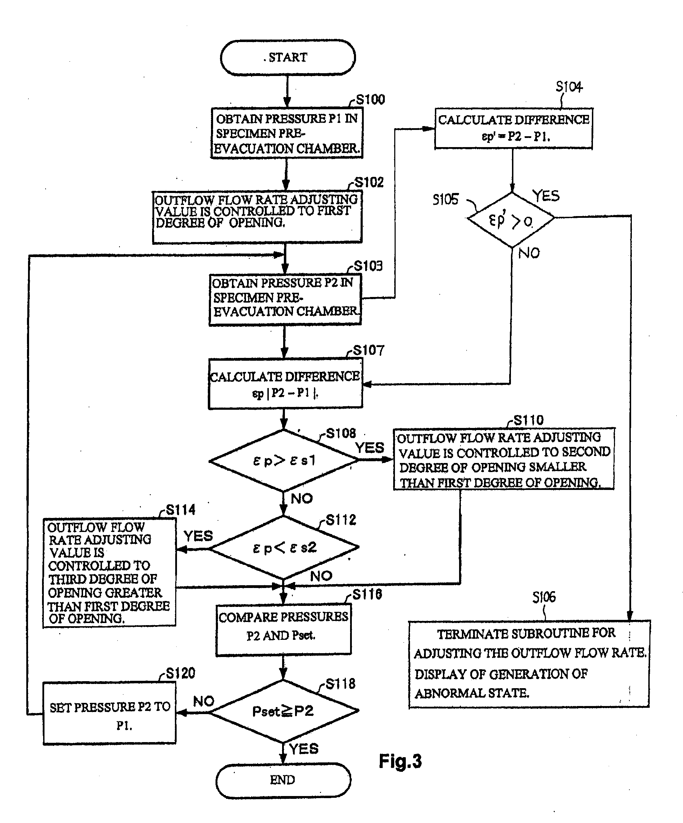

The processing performed by the controller 82 to adjust the outflow flow rate is first described by referring to FIGS. 2 and 3. FIG. 3 is a flowchart illustrating one example of the processing performed by the controller 82 of the charged particle beam instrument 100 associated with the present embodiment to adjust the outflow flow rate.

When a specimen is introduced into the specimen chamber 10 via the specimen pre-evacuation chamber 20, the specimen chamber exhaust valve 74 is open in the charged particle beam instrument 100. The specimen chamber 10 is evacuated to a high degree of vacuum, for example, of about 10⁻⁵ Pa by the vacuum pump 50. The outflow flow rate adjusting valve 70 and the inflow flow rate adjusting valve 72 are closed. The specimen pre-evacuation chamber 20 is at atmospheric pressure. The pump 40 is in operation. Under this condition, the specimen is introduced into the specimen pre-evacuation chamber 20. The controller 82 obtains a start signal, which is delivered, for example, when the user manipulates the manipulation portion 90, and initiates the processing for adjusting the outflow flow rate.

First, the controller 82 performs a step for obtaining information about the initial pressure P1 of the specimen pre-evacuation chamber 20 measured by the pressure gauge 30 (S100). The information about the initial pressure P1 is output from the pressure gauge 30. The controller 82 obtains the information about the initial pressure P1 output from the pressure gauge 30. The initial pressure P1 is the pressure inside the specimen pre-evacuation chamber 20 measured by the pressure gauge 30 before the outflow flow rate adjusting valve 70 is opened (i.e., before the first degree of opening is achieved).

Then, the controller 82 performs a step for controlling the outflow flow rate adjusting valve 70 to the first degree of opening (initial degree of opening) (S 102). In particular, the controller 82 generates a control signal for opening the adjusting valve 70 to the first degree of opening and sends the control signal to the outflow flow rate adjusting valve 70.

The controller 82 then performs a step of obtaining information about the current pressure P2 inside the specimen pre-evacuation chamber 20 measured by the pressure gauge 30 after the outflow flow rate adjusting valve 70 has been controlled to the first degree of opening (S103). Information about the current pressure P2 is output from the pressure gauge 30. The controller 82 obtains the information about the current pressure P2 delivered from the pressure gauge 30.

The controller 82 then performs a step of calculating the difference between the initial pressure P1 and the current pressure P2, εp'= P2 - P1, (S104). The controller 82 performs a step of making a decision as to whether the difference εp' is greater than 0 (S105). If the decision at S105 is YES (i.e., difference εp' is greater than 0 (εp' > 0)), the controller 82 determines that a fault has occurred in the pumping, forcibly terminates the processing for adjusting the outflow flow rate, and provides a display of occurrence of a fault on the display portion 92 (S 106).

If the controller 82 determines that the difference εp' is not greater than 0 (i.e., NO at step S105) indicating that the pumping is being conducted normally, the controller performs a step of calculating the difference between the initial pressure P1 and the current pressure P2, i.e., εp₂₋₁ = |P2 - P1|, (S107). The controller 82 then performs a step of making a decision as to whether the difference εp₂₋₁ is greater than the first reference value εs1 (S108).

If the controller 82 determines that the difference εp₂₋₁ is greater than the first reference value εs1 (εp₂₋₁ > εs1) (i.e., the decision at step S108 is YES), the controller performs a step of controlling the outflow flow rate adjusting valve 70 to a second degree of opening smaller than the first degree of opening (S 110). In particular, if the decision is that εp₂₋₁ > εs1, the controller 82 generates a control signal to control the outflow flow rate adjusting valve 70 to the second degree of opening and sends the control signal to the adjusting valve 70.

On the other hand, if the decision is that the difference εp₂₋₁ is not greater than the first reference value εs1 (i.e., the decision at step S108 is NO), the controller 82 performs a step of making a decision as to whether the difference εp₂₋₁ between the initial pressure P1 and the current pressure P2 is smaller than the second reference value εs2 (S 112).

If the decision is that the difference εp₂₋₁ is smaller than the second reference value εs2 (εp₂₋₁ < εs2) (i.e., decision at step S 112 is YES), the controller 82 performs a step of adjusting the outflow flow rate adjusting valve 70 to a third degree of opening greater than the first degree of opening (S114). In particular, if the decision is that εp₂₋₁ < εs2, the controller 82 generates a control signal to control the adjusting valve 70 to the third degree of opening and sends the control signal to the adjusting valve 70.

If the controller 82 determines that the difference εp₂₋₁ is not smaller than the second reference value εs2 after the step of controlling the outflow flow rate adjusting valve 70 to the second degree of opening (S110) (decision at step S112 is NO) or if the step of controlling the outflow flow rate adjusting valve 70 to the third degree of opening is done (S 114), then the controller performs a step of making a decision as to whether the current pressure P2 is equal to or less than a pressure value Pset necessary to introduce a specimen into the specimen chamber 10 (S116). For example, a pressure value inside the specimen chamber 10 measured by the pressure gauge 32 can be used as the pressure value Pset. That is, the controller 82 makes a decision as to whether the current pressure P2 inside the specimen pre-evacuation chamber 20 is equal to or less than the pressure inside the specimen chamber 10.

If the controller 82 determines that the current pressure P2 is equal to or less than the pressure value Pset (i.e., the decision at step S118 is YES), the controller performs a step of providing a display indicative of completion of pre-evacuation, for example, on the display portion 92 and ends the subroutine for adjusting the outflow flow rate. As a result, the gate valve 12 can be opened, and the specimen can be moved from the specimen pre-evacuation chamber 20 into the specimen chamber 10.

On the other hand, if the controller 82 determines that the current pressure P2 is not equal to or less than the pressure value Pset (i.e., the decision at step S118 is NO), the controller performs a step of setting the value of the current pressure P2 as the value of the initial pressure P1 (S120). Furthermore, the controller 82 performs a step of setting the current degree of opening of the outflow flow rate adjusting valve 70 as the first degree of opening (initial degree of opening). The controller 82 then performs the step of obtaining information about the current pressure P2 (S103). The controller 82 repeats the steps S103, S104, S105, S106, S107, S108, S110, S 112, S 114, S 116, S 118, and S120 until the current pressure P2 is judged to be equal to or or less than Pset (decision at step S118 is YES).

### 2.2. Processing for Adjusting Inflow Flow Rate

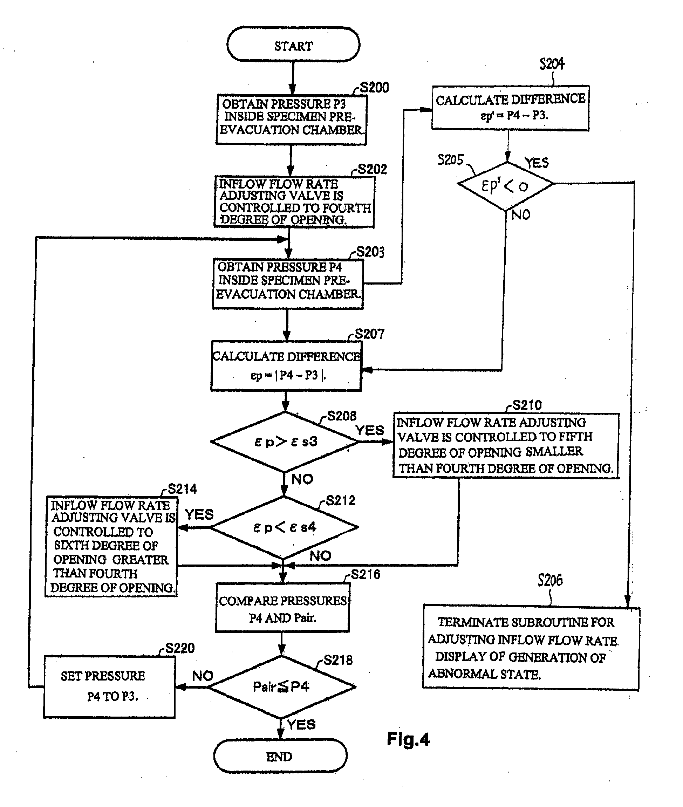

The processing performed by the controller 82 to adjust the outflow flow rate is next described by referring to FIGS. 2 and 4. FIG. 4 is a flowchart illustrating one example of the processing performed by the controller 82 of the charged particle beam instrument 100 associated with the present embodiment to adjust the outflow flow rate.

When the specimen is taken out of the specimen chamber 10 via the specimen pre-evacuation chamber 20, the specimen chamber exhaust valve 74 in the charged particle beam instrument 100 is open. The specimen chamber 10 is being evacuated to a high degree of vacuum by the vacuum pump 50. Also, the outflow flow rate adjusting valve 70 is open. The specimen pre-evacuation chamber 20 is being pumped down to a high degree of vacuum by the vacuum pump 40. Under this condition, the gate valve 12 is opened, and the specimen is moved from the specimen chamber 10 into the specimen pre-evacuation chamber 20. Then, the gate valve 12 and outflow flow rate adjusting valve 70 are closed. The controller 82 obtains a start signal, which is output, for example, when the user manipulates the manipulation portion 90, and starts the processing (subroutine) for adjusting the outflow flow rate.

First, the controller 82 performs a step of obtaining information about the initial pressure P3 inside the specimen pre-evacuation chamber 20 measured by the pressure gauge 30 (S200). The information about the initial pressure P3 is output from the pressure gauge 30. The controller 82 obtains the information about the initial pressure P3 delivered from the pressure gauge 30. In this example, the initial pressure P3 is measured by the pressure gauge 30 and is the pressure inside the specimen pre-evacuation chamber 20 before the inflow flow rate adjusting valve 72 is opened (i.e.., the valve is controlled to the fourth degree of opening).

The controller 82 then performs a step of opening the inflow flow rate adjusting valve 72 to the fourth degree of opening (initial degree of opening) (S202). In particular, the controller 82 generates a control signal to open the inflow flow rate adjusting valve 72 to the fourth degree of opening and sends the control signal to the inflow flow rate adjusting valve 72.

Then, the controller 82 performs a step of obtaining information about the current pressure P4 inside the specimen pre-evacuation chamber 20 measured by the pressure gauge 30 after the inflow flow rate adjusting valve 72 has been controlled to the fourth degree of opening (S203). Information about the current pressure P4 is output from the pressure gauge 30. The controller 82 obtains the information about the current pressure P4 delivered from the pressure gauge 30.

The controller 82 then performs a step of calculating the difference εp' = P4 - P3 between the initial pressure P3 and the current pressure P4 (S204). The controller 82 performs a step of making a decision as to whether the difference εp' is smaller than 0 (S205). If the decision is that the difference εp' is smaller than 0 (εp'< 0) (YES at step S205), the controller 82 determines that the processing for introducing a gas is at fault, forcibly terminates the subroutine for adjusting the inflow flow rate, and provides a display of generation of a fault on the display portion 92 (S206).

If the controller 82 determines that the difference εp' is not less than 0 (i.e., the decision at step S205 is NO) indicating that the processing for introducing a gas is being carried out normally, the controller performs a step of calculating the difference εp₄₋₃ = |P4 - P3| between the initial pressure P3 and the current pressure P4 (S207). The controller 82 then performs a step of making a decision as to whether the difference εp₄₋₃ is greater than the third reference value εs3 (S208).

If the controller 82 determines that the difference εp₄₋₃ is greater than the third reference value εs3 (εp₄₋₃ > εs3) (YES at step S208), the controller performs a step of controlling the inflow flow rate adjusting valve 72 to a fifth degree of opening smaller than the fourth degree of opening (S210). In particular, if the decision is that εp₄₋₃ > εs3, the controller 82 generates a control signal for controlling the inflow flow rate adjusting valve 72 to the fifth degree of opening and sends the control signal to the inflow flow rate adjusting valve 72.

On the other hand, if the controller 82 determines that the difference εp₄₋₃ is not greater than the third reference value εs3 (NO at step S208), the controller performs a step of making a decision as to whether the difference εp₄₋₃ between the initial pressure P3 and the current pressure P4 is smaller than the fourth reference value εs4 (S212).

If the controller 82 determines that the difference εp₄₋₃ is smaller than the fourth reference value εs4 (εp₄₋₃ < εs4) (i.e., YES at step S212), the controller performs a step of controlling the inflow flow rate adjusting valve 72 to a sixth degree of opening greater than the fourth degree of opening (S214). In particular, if the controller 82 determines that εp₄₋₃ < εs4, the controller generates a control signal for controlling the outflow flow rate adjusting valve 70 to the sixth degree of opening and sends the control signal to the inflow flow rate adjusting valve 72.

After performing the step of controlling the inflow flow rate adjusting valve 72 to the fifth degree of opening (S210), if the controller 82 determines that the difference εp₄₋₃ is not smaller than the third reference value εs3 (NO at step S212) or if the step of controlling the inflow flow rate adjusting valve 72 to the sixth degree of opening (S214) is performed, the controller performs a step of making a decision as to whether the current pressure P4 is equal to or greater than a pressure value Pair necessary to take out the specimen (S216). For example, an outside pressure value (atmospheric pressure) measured by the pressure gauge 34 can be used as the pressure value Pair. That is, the controller 82 makes a decision as to whether the current pressure P4 inside the specimen pre-evacuation chamber 20 is equal to or higher than atmospheric pressure.

If the controller 82 determines that the current pressure P4 is equal to or higher than the pressure value Pair (YES at step S218), the controller provides a display on the display portion 92 to the effect that venting is complete and terminates the subroutine. As a result, the specimen can be taken out of the specimen pre-evacuation chamber 20.

On the other hand, if the controller 82 determines that the current pressure P4 is not equal to or higher than the pressure value Pair (NO at step S218), the controller performs a step of setting the value of the current value P4 as the value of the initial pressure P3 (S220). Furthermore, the controller 82 performs a step of setting the current degree of opening of the inflow flow rate adjusting valve 72 to the fourth degree of opening (initial degree of opening). The controller 82 performs a step of obtaining information about the current pressure P4 (S203). The controller 82 repeats the steps S203, S204, S205, S206, S207, S208, S210, S212, S214, S216, S218, and S220 until the current pressure P4 is judged to be equal to or greater than Pair (YES at step S218).

The charged particle beam instrument 100 associated with the present embodiment has the following features.

The charged particle beam instrument 100 performs an operation for making a decision as to whether the difference εp₂₋₁ between the initial pressure P1 inside the pre-evacuation chamber 20 measured by the pressure gauge 30 before the outflow flow rate adjusting valve 70 is controlled to the first degree of opening (initial degree of opening) and the current pressure P2 inside the specimen pre-evacuation chamber 20 measured by the pressure gauge 30 after the adjusting valve 70 has been controlled to the first degree of opening is greater than the first reference value εs1 and an operation for controlling the outflow flow rate adjusting valve 70 to the second degree of opening smaller than the first degree of opening if the difference between the initial pressure P1 and the current pressure P2 is judged to be greater than the first reference value εs1. Consequently, when the specimen pre-evacuation chamber 20 is pre-evacuated, large pressure variations which would normally damage or scatter the specimen can be prevented. Hence, the charged particle beam instrument 100 can prevent damage and scattering of the specimen in the specimen pre-evacuation chamber 20.

Furthermore, in the charged particle beam instrument 100, if the difference εp₂₋₁ between the initial pressure P1 and the current pressure P2 is judged to be smaller than the second reference value εs2, a step of controlling the outflow flow rate adjusting valve 70 to the third degree of opening greater than the first degree of opening is performed. In consequence, the specimen pre-evacuation chamber 20 can be evacuated efficiently.

Therefore, according to the charged particle beam instrument 100, during pre-evacuation of the specimen pre-evacuation chamber 20, the range of variable pressure (difference εp₂₋₁) inside the specimen pre-evacuation chamber 20 can be set to a preset range (εs2 ≤ εp₂₋₁ ≤ εs1). Consequently, in the charged particle beam instrument 100, damage and scattering of the specimen in the specimen pre-evacuation chamber 20 can be prevented and the chamber 20 can be evacuated efficiently. Furthermore, in the charged particle beam instrument 100, the outflow flow rate can be controlled accurately by controlling the outflow flow rate adjusting valve 70. For example, the chamber can be evacuated from atmospheric pressure by the vacuum pump 40 (such as a turbomolecular pump) without using a roughing pump. Accordingly, the configuration of the exhaust system can be simplified.

The charged particle beam instrument 100 performs the operation for making a decision as to whether the difference εp₄₋₃ between the initial pressure P3 inside the specimen pre-evacuation chamber 20 measured by the pressure gauge 30 before the inflow flow rate adjusting valve 72 is controlled to the fourth degree of opening (initial degree of opening) and the current pressure P4 inside the specimen pre-evacuation chamber 20 measured by the pressure gauge 30 after the inflow flow rate adjusting valve 72 has been controlled to the fourth degree of opening is greater than the third reference value εs3 and the operation for controlling the inflow flow rate adjusting valve 72 to the fifth degree of opening smaller than the fourth degree of opening if the difference εp₄₋₃ between the initial pressure P3 and the current pressure P4 is judged to be greater than the third reference value εs3. Consequently, when the specimen pre-evacuation chamber 20 is vented, large pressure variations which would normally damage or scatter the specimen can be prevented. Accordingly, in the charged particle beam instrument 100, damage and scattering of the specimen in the specimen pre-evacuation chamber 20 can be prevented.

Additionally, if the difference εp₄₋₃ between the initial pressure P3 and the current pressure P4 is judged to be smaller than the fourth reference value εs4, the charged particle beam instrument 100 performs a step of controlling the inflow flow rate adjusting valve 72 to a sixth degree of opening greater than the fourth degree of opening. As a consequence, the specimen pre-evacuation chamber 20 can be vented efficiently.

Accordingly, in the charged particle beam instrument 100, during venting of the specimen pre-evacuation chamber 20, the range of pressure variation inside the specimen pre-evacuation chamber 20 (difference εp₄₋₃) can be made equal to a predetermined range, εs4 ≤ εp₂₋₁ ≤ εs3. Therefore, in the charged particle beam instrument 100, damage and scattering of the specimen in the pre-evacuation chamber 20 can be prevented. Furthermore, the pre-evacuation chamber 20 can be vented efficiently.

### 3. Modifications of Charged Particle Beam Instrument

Modifications of the present embodiment are next described.

### (1) First Modification

A first modification is first described.

The controller 82 of the above-described charged particle beam instrument 100 controls variations of the pressure inside the specimen pre-evacuation chamber 20 by controlling the degree of opening of the outflow flow rate adjusting valve 70 during the processing for adjusting the outflow flow rate. Alternatively, during the processing for adjusting the outflow flow rate, the controller 82 may control the variation in the pressure inside the specimen pre-evacuation chamber 20 by controlling the degrees of opening of both outflow flow rate adjusting valve 70 and inflow flow rate adjusting valve 72.

In particular, the controller 82 may control the degree of opening of the inflow flow rate adjusting valve 72 as well as the degree of opening of the outflow flow rate adjusting valve 70 during the step S102 of controlling the adjusting valve 70 to the first degree of opening, the step S 110 of controlling the adjusting valve 70 to the second degree of opening, and the step S 114 of controlling the adjusting valve 70 to the third degree of opening as illustrated in FIG. 3.

The controller 82 of the charged particle beam instrument 100 controls the variation in the pressure inside the specimen pre-evacuation chamber 20 by controlling the degree of opening of the inflow flow rate adjusting valve 72 during the subroutine for adjusting the inflow flow rate as described previously. In contrast, the controller 82 may control the variation in the pressure inside the specimen pre-evacuation chamber 20 by controlling the degrees of opening of both inflow flow rate adjusting valve 72 and outflow flow rate adjusting valve 70 during the subroutine for adjusting the inflow flow rate.

Specifically, the controller 82 controls the degree of opening of the inflow flow rate adjusting valve 72 in the step S202 of controlling the inflow flow rate adjusting valve 72 to the fourth degree of opening, in the step S210 of controlling the inflow flow rate adjusting valve 72 to the fifth degree of opening, and in the step S214 of controlling the inflow flow rate adjusting valve 72 to the sixth degree of opening as illustrated in FIG. 4. Furthermore, the controller may control the degree of opening of the outflow flow rate adjusting valve 70. Consequently, unlike the case where only the inflow flow rate adjusting valve 72 is used, the interior of the specimen pre-evacuation chamber 20 can be made an ambient of the gas (such as inert gas ambient) supplied from the gas supply portion 60. Consequently, the effects of the outside air on the specimen can be reduced.

### (2) Second Modification

A second modification is next described.

The aforementioned controller 82 performs the steps (S100, S103) of obtaining information about the initial pressure P1 and information about the current pressure P2 inside the specimen pre-evacuation chamber 20 as depicted in FIG. 3 in the subroutine of adjusting the outflow flow rate. Furthermore, the controller 82 may obtain information about a time T1 for which the initial pressure P1 is measured and information about a time T2 for which the current pressure P2 is measured. In addition, the controller 82 may perform a step of calculating the difference between the times T1 and T2 and calculating a pressure variation value per unit time in the specimen pre-evacuation chamber 20 from the time difference |T2 - T1| and from the difference εp₂₋₁. The controller 82 may control the degree of opening of the outflow flow rate adjusting valve 70 based on the calculated pressure variation value per unit time.

In the above-described subroutine for adjusting the inflow flow rate, the controller 82 performs the steps (S200, S203) of obtaining information about the initial pressure P3 inside the specimen pre-evacuation chamber 20 and information about the current pressure P4 as illustrated in FIG. 4. Furthermore, the controller 82 may obtain information about a time T3 for which the initial pressure P3 is measured and information about a time T4 for which the current pressure P4 is measured. Additionally, the controller 82 may perform a step of calculating the difference between the times T3 and T4 and calculating the pressure variation value per unit time in the specimen pre-evacuation chamber 20 from the time difference |T4 - T3| and from the difference εp₄₋₃. Then, the controller 82 may control the degree of opening of the inflow flow rate adjusting valve 72 based on the calculated pressure variation value per unit time.

In the description of the above-described embodiment and modifications, the charged particle beam instrument is a transmission electron microscope. No restrictions are placed on the charged particle beam instrument associated with the present invention as long as the instrument employs a beam of charged particles such as electrons or ions. The charged particle beam instrument associated with the present invention may be an electron microscope (such as a scanning transmission electron microscope (STEM) or a scanning electron microscope (SEM)), an electron beam microanalyzer (EPMA), a focused ion beam (FIB) instrument, an electron beam exposure system, or the like.

The present invention embraces configurations (e.g., configurations identical in function, method, and results or identical in purpose and advantageous effects) which are substantially identical to the configurations described in connection with the above embodiment. Furthermore, the invention embraces configurations which are similar to the configurations described in connection with the above embodiment except that their nonessential portions have been replaced. Further, the invention embraces configurations which are similar to the configurations described in connection with the above embodiment except that a well-known technique is added.

## Claims

1. A charged particle beam instrument comprising:
a specimen chamber maintained at a vacuum;
a specimen pre-evacuation chamber connected with the specimen chamber via a gate valve;
a vacuum pump for evacuating the specimen pre-evacuation chamber;
an outflow flow rate adjusting valve for adjusting the flow rate of gas exhausted from the specimen pre-evacuation chamber by the vacuum pump;
a pressure gauge for measuring the pressure inside the specimen pre-evacuation chamber; and
a controller for controlling the outflow flow rate adjusting valve;
wherein said controller performs an operation for controlling the outflow flow rate adjusting valve to a first degree of opening, an operation for making a decision as to whether the difference between a first pressure inside the specimen pre-evacuation chamber measured by the pressure gauge before the outflow flow rate adjusting valve is controlled to the first degree of opening and a second pressure inside the specimen pre-evacuation chamber measured by the pressure gauge after the outflow flow rate adjusting valve has been controlled to the first degree of opening is greater than a first reference value, and an operation for controlling the outflow flow rate adjusting valve to a second degree of opening smaller than the first degree of opening if the decision is affirmative to indicate that the difference between the first and second pressures is greater than the first reference value.

2. A charged particle beam instrument as set forth in claim 1, wherein said controller performs an operation for making a decision as to whether the difference between the first and second pressures is smaller than a second reference value and an operation for controlling the outflow flow rate adjusting value to a third degree of opening greater than the first degree of opening if the decision is affirmative to indicate that the difference between the first and second pressures is smaller than the second reference value.

3. A charged particle beam instrument as set forth in any one of claims 1 and 2, further comprising: a gas supply portion for introducing gas into said specimen pre-evacuation chamber; and an inflow flow rate adjusting valve for adjusting the flow rate of the gas introduced into the specimen pre-evacuation chamber by the gas supply portion;
wherein said controller further operates to control the inflow flow rate adjusting valve; and
wherein the controller performs an operation for controlling the inflow flow rate adjusting valve to a fourth degree of opening, an operation for making a decision as to whether the difference between a third pressure inside the specimen pre-evacuation chamber measured by the pressure gauge before the inflow flow rate adjusting valve is controlled to the fourth degree of opening and a fourth pressure inside the specimen pre-evacuation chamber measured by the pressure gauge after the inflow flow rate adjusting valve has been controlled to the fourth degree of opening is greater than a third reference value, and an operation for controlling the inflow flow rate adjusting valve to a fifth degree of opening smaller than the fourth degree of opening if the decision is affirmative to indicate that the difference between the third and fourth pressures is greater than the third reference value.

4. A charged particle beam instrument as set forth in claim 3, wherein said controller performs an operation for making a decision as to whether the difference between the third and fourth pressures is smaller than a fourth reference value and an operation for controlling the inflow flow rate adjusting valve to a sixth degree of opening greater than the fourth degree of opening if the decision is affirmative to indicate that the difference between the third and fourth pressures is smaller than the fourth reference value.

5. A charged particle beam instrument comprising:
a specimen chamber maintained at a vacuum;
a specimen pre-evacuation chamber connected with the specimen chamber via a gate valve;
a gas supply portion for introducing gas into the specimen pre-evacuation chamber;
an inflow flow rate adjusting valve for adjusting the flow rate of the gas introduced into the specimen pre-evacuation chamber by the gas supply portion;
a pressure gauge for measuring the pressure inside the specimen pre-evacuation chamber; and
a controller for controlling the inflow flow rate adjusting valve;
wherein said controller performs an operation for controlling the inflow flow rate adjusting valve to a fourth degree of opening, an operation for making a decision as to whether the difference between a third pressure inside the specimen pre-evacuation chamber measured by the pressure gauge before the inflow flow rate adjusting valve is controlled to the fourth degree of opening and a fourth pressure inside the specimen pre-evacuation chamber measured by the pressure gauge after the inflow flow rate adjusting valve has been controlled to the fourth degree of opening is greater than a third reference value, and an operation for controlling the inflow flow rate adjusting valve to a fifth degree of opening smaller than the fourth degree of opening if the decision is affirmative to indicate that the difference between the third and fourth pressures is greater than the third reference value.
